# FASCICULE DE BREVET EUROPEEN

(11) **EP 2 071 340 B1**
(45) Date de publication et mention de la délivrance du brevet: **06.11.2013**
(21) Numéro de dépôt: 08305880.0
(22) Date de dépôt: 04.12.2008
(51) Int. Cl.: G01P 1/02, G01P 15/08, G01P 15/125

(54) **Accéléromètre pendulaire et procédé de fabrication de celui-ci**
Pendelbeschleunigungsmesser und sein Herstellungsverfahren
Pendular accelerometer and manufacturing method thereof

(30) Priorité: 11.12.2007 FR 0759753
(43) Date de publication de la demande: 17.06.2009
(73) Titulaire: Memscap, 38920 Crolles (FR)
(72) Inventeur: Wenk, Béatrice, 38100, GRENOBLE (FR); Veneau, Jean-François, 38320, EYBENS (FR); Hames, Greg, RALEIGH, NC 27614 (US)
(74) Mandataire: Palix, Stéphane

(56) Documents cités:
- FR-A- 2 763 694
- US-A- 5 616 844
- US-A- 5 905 203
- US-A1- 2007 062 285

## Description

### DOMAINE DE L'INVENTION

L'invention a trait au domaine des accéléromètres et gyromètres pendulaires.

### ETAT ANTERIEUR DE LA TECHNIQUE

Un accéléromètre pendulaire est destiné à mesurer l'accélération qu'il subit dans une direction perpendiculaire à son plan principal. Il comprend usuellement une électrode plate formée dans une galette SOI (pour « Silicium on Isolator ») et apte à effectuer un mouvement de rotation autour d'un axe compris dans son plan (on parle alors d'électrode « pendulaire »), deux contre-électrodes en regard de l'électrode pendulaire et formant avec celle-ci deux capacités variables en fonction de l'angle de rotation de l'électrode pendulaire, le tout étant encapsulé sous un capot hermétique et placé sous une pression réduite. Un tel accéléromètre est par exemple décrit dans le document US-A-5 905 203.

Jusqu'ici les contre-électrodes sont placées sous l'électrode pendulaire et les connexions électriques à l'électrode et aux contre-électrodes sont réalisées dans la galette SOI. Ceci implique notamment d'avoir un schéma compliqué de connexions électriques dans la galette SOI, et par conséquent un encombrement important de celle-ci, d'utiliser pour les contre-électrodes des matériaux compatibles avec celui de la galette SOI, et par conséquent des matériaux non métalliques.

Tout comme l'accéléromètre pendulaire décrit précédemment, un gyromètre pendulaire comprend également une électrode pendulaire mobile associé à des contre-électrodes formées dans une galette SOI, et présente donc des inconvénients identiques.

Le document FR 2 763 694 présente une méthode de fabrication d'un capteur comportant un capot d'encapsulation.

### EXPOSE DE L'INVENTION

Le but de la présente invention est de résoudre le problème susmentionné en proposant un capteur d'accélération pendulaire, notamment un accéléromètre ou un gyromètre, dont les contre-électrodes sont dissociées de la galette dans laquelle est formée l'électrode pendulaire, permettant notamment une réduction, voire une disparition, des connexions électriques dans celles-ci, et un choix libre de matériau pour les contre-électrodes.

A cet effet, l'invention a pour objet un procédé de fabrication d'un capteur d'accélération pendulaire, notamment un accéléromètre ou un gyromètre, comportant la formation d'une électrode pendulaire dans l'épaisseur d'un substrat.

Selon l'invention, ce procédé est caractérisé en ce qu'il comporte les étapes de :
■ formation d'un capot d'encapsulation pourvu d'au moins une contre-électrode sous celui-ci ;
■ formation d'entretoises de longueur prédéterminée sous le capot et/ou sur le substrat ;
■ plaquage d'un revêtement eutectique sous le capot et/ou sur le substrat, l'épaisseur du revêtement étant supérieure à la longueur des entretoises ;
■ positionnement du capot sur le substrat ; et
■ fusion du revêtement eutectique.

En d'autres termes, la ou les contre-électrodes sont placées sous le capot d'encapsulation. La formation d'entretoises et le placement du capot par fusion du revêtement eutectique permet de commander avec précision la distance séparant les contre-électrodes de l'électrode pendulaire, et cela sans détériorer par un choc thermique les éléments de l'accéléromètre lors de la fusion du revêtement en raison de la température de fusion basse de celui-ci.

Jusqu'à présent le placement des contre-électrodes sous le capot est difficile car il fallait commander avec précision la distance entre les contre-électrodes et l'électrode pendulaire pour obtenir un accéléromètre précis. Lors de la fusion du revêtement, le capot repose sur le substrat via les entretoises dont la longueur est précisément contrôlée lors de leur fabrication.

En outre, le fait que les contre-électrodes soient placées sous le capot permet une connexion électrique de celle-ci au travers du capot. Il n'est donc pas besoin de prévoir de telles connexions dans ou sous le substrat de l'électrode pendulaire. De plus, un large choix de matériau pour celles-ci peut être envisagé du fait de leur indépendance vis-à-vis du substrat.

Selon des modes de réalisation particuliers de l'invention, le procédé comprend une ou plusieurs des caractéristiques suivantes.

L'étape de formation du capot comprend une étape de formation d'une traversée dans le capot pour la connexion électrique de la au moins une contre-électrode.

L'étape de formation du capot comprend une étape de formation d'un élément de connexion électrique sous le capot pour la connexion électrique de l'électrode pendulaire, et une étape de formation d'une traversée dans le capot pour la connexion électrique dudit élément.

Le matériau eutectique est un alliage d'or et de silicium, un alliage d'or et d'indium, ou un alliage d'or et d'étain.

L'intégration d'un getter entre le capot et le substrat.

L'invention a également pour objet un capteur d'accélération pendulaire, comprenant une électrode pendulaire formée dans un substrat, au moins une contre-électrode et un capot d'encapsulation, caractérisé en ce que la au moins une contre-électrode est formée sous le capot, et en ce qu'il comprend des entretoises positionnées entre le capot et le substrat.

Notamment le capteur est un accéléromètre apte à mesurer une accélération linéaire ou un gyromètre apte à mesurer une accélération angulaire.

### BREVE DESCRIPTION DES FIGURES

L'invention sera mieux comprise à la lecture de la description qui va suivre, donnée uniquement à titre d'exemple, et faire en relation avec les dessins annexés, dans lesquels des références identiques désignent des éléments identiques ou analogues, et dans lesquels :
- la figure 1 est une vue en coupe d'un accéléromètre selon l'invention ; et
- les figures 2 à 10 illustre un procédé de fabrication de l'accéléromètre de la figure 1.

### DESCRIPTION DETAILLEE DE L'INVENTION

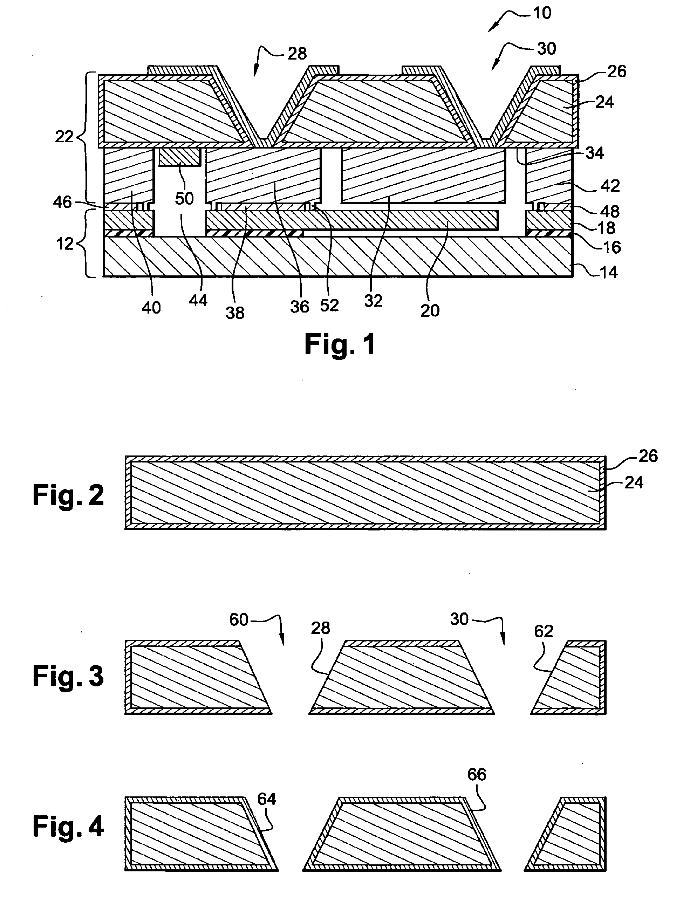

Sur la figure 1, un accéléromètre 10 comprend une tranche de substrat SOI 12 avec une première couche de silicium (Si) 14, une couche sacrificielle isolante 16 de dioxyde de silicium (SiO₂) appliquée sur la première couche de silicium 14, et une troisième couche de Si 18, appliquée sur la seconde couche 16.

Une électrode pendulaire 20 est par ailleurs réalisée dans la seconde couche 18, par exemple au moyen d'une attaque chimique du type DRIE (pour « Deep Reactive Ion Etching »).

Un capot d'encapsulation 22 est également prévu et comprend une couche de Si 24 recouverte d'un oxyde thermique 26 et pourvue de deux traversées métallisées 28, 30.

Une contre-électrode 32 est par ailleurs agencée sous la surface inférieure 34 de la couche 24 en regard de l'électrode pendulaire 20 et est connectée à la traversée métallisée 30.

Un bloc de connexion électrique 36 est également agencé sous la surface inférieure 34 de la couche de Si 24. Ce bloc 36 est connecté à l'électrode pendulaire 20 via un matériau métallique 38 et à la traversée métallisée 28.

Le capot 32 comprend en outre des parois latérales 40, 42 définissant, avec le substrat 12 et la couche 24, un espace interne 44 dans lequel sont encapsulées l'électrode pendulaire 20 et la contre-électrode 32. Cet espace 44 est de préférence rendu hermétique au moyens de joints 46, 48 et placé sous vide. Dans certains cas, un getter 50 est par ailleurs prévu à cet effet sous la surface 44 du capot 22.

Enfin, des entretoises 52 sont agencées entre le substrat SOI 12 et le capot 22 pour régler avec précision la distance séparant l'électrode pendulaire 20 de la contre-électrode 32.

Un procédé de fabrication de l'accéléromètre 10 va maintenant être décrit en relation avec les figures 2 à 10.

Dans une première étape (figure 2), une tranche de silicium 24 de 250 micromètres d'épaisseur est recouverte d'une couche 26 de 2 micromètres d'oxyde thermal.

Dans une étape suivante (figure 3), deux traversées 28, 30 sont formées dans l'épaisseur de la tranche 24, par exemple au moyen d'une lithographie suivie d'une attaque chimique par KOH. Ensuite (figure 4), les parois latérales 60, 62 des traversées 28, 30 sont recouvertes d'une couche 64, 66 de 2 micromètres d'oxyde thermal au moyen d'une oxydation.

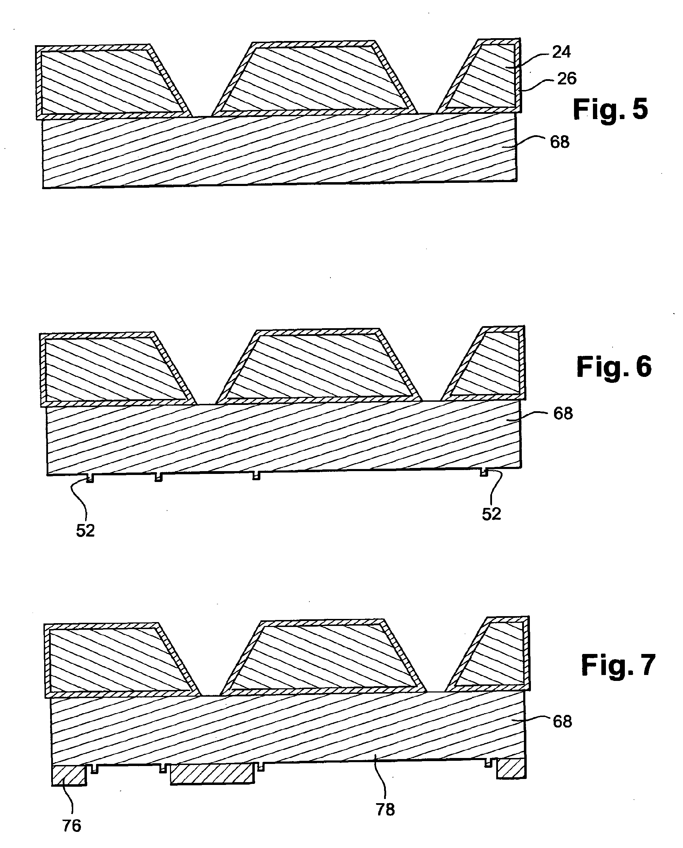

Dans une étape suivante (figure 5), une tranche de silicium 68, d'une épaisseur de 250 micromètre est collée par fusion sous la tranche 24. Des entretoises 52 sont ensuite formées sur la surface inférieure de la tranche 68 par lithographie et attaque chimique (figure 6).

Dans une étape suivante (figure 7), la portion 74 de la couche d'oxyde thermal 70 recouvrant les parois latérales de la tranche 68 est éliminée par attaque chimique. Des blocs 76 d'alliage d'or et de silicium sont alors formés par électroformage (ou « *electroplating* ») sur la surface inférieure 78 de la tranche 68, l'épaisseur de ces blocs étant supérieure à la longueur des entretoises 52 de manière à ce que le capot 22, une fois posé sur le substrat 12, repose sur ceux-ci.

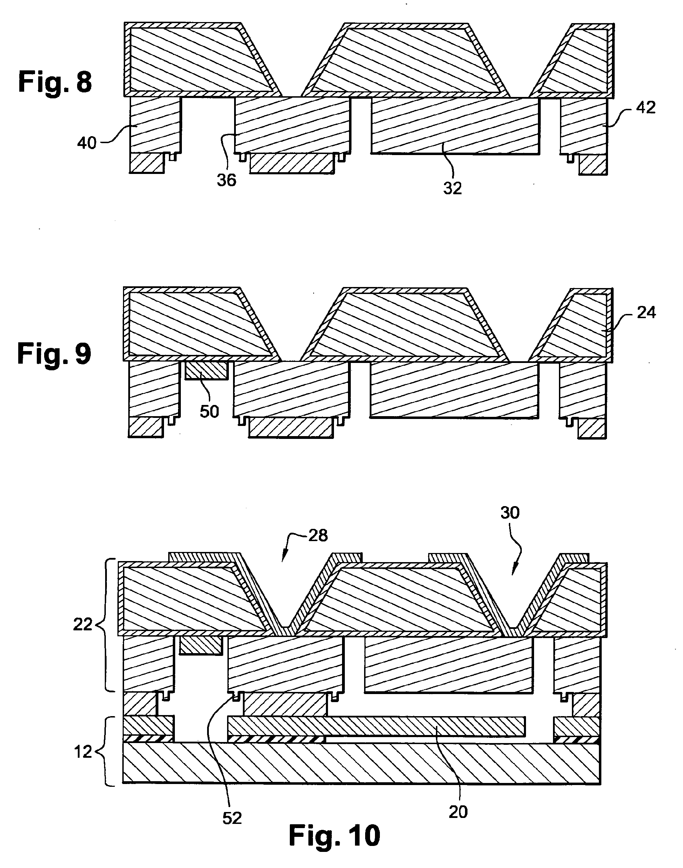

Dans une étape suivante (figure 8), les différents éléments fonctionnels du capot, à savoir le bloc de connexion électrique 36, la contre-électrode 32 et les parois latérales 40, 42, sont réalisés par lithographie et attaque du type DRIE (pour « Deep Reactive Ion Etching »). Le cas échéant, le getter 50 est ensuite déposé sous la tranche 24 (figure 9).

Le capot 22 ainsi obtenu est alors posé (figure 10) sur la tranche SOI 12 dans laquelle a été formée l'électrode pendulaire 20. Le capot 22 repose alors sur les blocs 76.

Dans une étape finale, le tout est porté à une température d'environ 400°C. A cette température, l'alliage d'or et de silicium, qui forme un système binaire eutectique dont la température eutectique est de 363°C, fond et agit comme une brasure.

Sous l'effet de la fusion de l'alliage d'or et de silicium, le capot 22 s'affaisse alors, l'affaissement du capot 22 se terminant une fois les entretoises 52 entrée en contact avec la tranche de substrat 12. On notera par ailleurs que la température de 400°C est trop faible pour endommager les organes de l'accéléromètre 10, raison pour laquelle il a été choisi un système binaire eutectique.

Une fois fondu, l'alliage d'or et de silicium forme donc des joints 46, 48 fermant de manière hermétique l'espace interne 44 de l'accéléromètre 10. Cet alliage assure en outre la conduction électrique du bloc de connexion 36 vers l'électrode pendulaire 20.

Les parois des traversées 28, 30 sont alors métallisées.

Il a été décrit un mode de réalisation particulier de l'invention. Bien entendu d'autres modes de réalisation sont possibles.

En variante, plutôt que l'alliage d'or et de silicium, un alliage d'or et d'indium (In) ou un alliage d'or et d'étain (Sn) est utilisé.

Il a été décrit un procédé de fabrication d'un accéléromètre pendulaire. Le procédé venant d'être décrit s'applique également à la fabrication d'un gyromètre comprenant une électrode pendulaire et des contre-électrodes.

Grâce à l'invention, il est ainsi obtenu les avantages suivants :
■ la ou les contre-électrodes sont disposées sous le capot et non plus dans le substrat dans lequel est formé l'électrode pendulaire. Le choix des matériaux pour les contre-électrodes est alors libre car il n'y a plus de contrainte de compatibilité avec le substrat comme cela état le cas dans l'état de la technique. En outre les connexions électriques sont également déportées dans le capot. Il n'est donc pas besoin de prévoir de connexion électrique dans le substrat. Les dimensions de celui-ci peuvent donc être sensiblement diminuées et la fabrication de l'accéléromètre ou du gyromètre en est facilitée.
■ la distance entre la ou les contre-électrodes et l'électrode pendulaire est réglée de manière précise grâce à la présence des entretoises et l'assemblage particulier du substrat et du capot par fusion d'un matériau eutectique. La précision de l'accéléromètre ou du gyromètre est donc préservée. En outre, la fabrication de l'accéléromètre ou du gyromètre est facilitée.
■ l'ensemble des connexions électriques est réalisée au travers du capot et il n'existe chemin préférentiel de fuite au niveau des connexions électriques dans l'accéléromètre ou le gyromètre. Les fuites sont ainsi minimisées ; et
■ le procédé de fabrication selon l'invention permet l'intégration sur un même composant électronique d'un accéléromètre trois axes et/ou un gyromètre trois axes.

## Revendications

1. Procédé de fabrication d'un capteur d'accélération pendulaire (10) comportant la formation d'une électrode pendulaire (20) dans l'épaisseur d'un substrat (12), comportant les étapes de :
■ formation d'un capot d'encapsulation (22) pourvu d'au moins une contre-électrode (32) sous celui-ci ;
■ formation d'entretoises (52) de longueur prédéterminée sous le capot (22) et/ou sur le substrat (12) ; et **caractérisé en ce qu'**il comporte les étapes de :
■ plaquage d'un matériau eutectique (76) sous le capot (22) et/ou sur le substrat (12), l'épaisseur du matériau étant supérieure à la longueur des entretoises ;
■ positionnement du capot (22) sur le substrat (12) ; et
■ fusion du matériau eutectique (76).

2. Procédé selon la revendication 1, **caractérisé en ce que** l'étape de formation du capot comprend une étape de formation d'une traversée (30) dans le capot (22) pour la connexion électrique de la au moins une contre-électrode (32).

3. Procédé selon la revendication 1 ou 2, **caractérisé en ce que** l'étape de formation du capot comprend une étape de formation d'un élément de connexion électrique (36) sous le capot pour la connexion électrique de l'électrode pendulaire (20), et une étape de formation d'une traversée (28) dans le capot (22) pour la connexion électrique dudit élément (36).

4. Procédé selon l'une quelconque des revendications précédentes, **caractérisé en ce que** le matériau eutectique est un alliage d'or et de silicium, un alliage d'or et d'indium, ou un alliage d'or et d'étain.

5. Procédé selon l'une quelconque des revendications précédentes, **caractérisé en ce qu'**il comporte en outre l'intégration d'un getter (50) entre le capot (22) et le substrat (12).

6. Procédé selon l'une quelconque des revendications précédentes, **caractérisé en ce que** ledit capteur est un accéléromètre apte à mesurer une accélération linéaire.

7. Procédé selon l'une quelconque des revendications 1 à 5, **caractérisé en ce que** ledit capteur est étant un gyromètre apte à mesurer une accélération angulaire.

## Patentansprüche

1. Verfahren zur Herstellung eines Pendelbeschleunigungssensors (10), die Ausbildung einer Pendelelektrode (20) in der Dicke eines Substrats (12) umfassend, die folgenden Schritte umfassend:
■ Ausbildung einer Verkapselungshaube (22), die mit mindestens einer Gegenelektrode (32) unter dieser versehen ist;
■ Ausbildung von Abstandshaltern (52) vorbestimmter Länge unter der Haube (22) und/oder auf dem Substrat (12);
und **dadurch gekennzeichnet, dass** es die folgenden Schritte umfasst:
■ Aufplattieren eines eutektischen Materials (76) unter der Haube (22) und/oder auf dem Substrat (12), wobei die Dicke des Materials größer ist als die Länge der Abstandshalter;
■ Positionieren der Haube (22) auf dem Substrat (12); und
■ Schmelzen des eutektischen Materials (76).

2. Verfahren nach Anspruch 1, **dadurch gekennzeichnet, dass** der Schritt der Ausbildung der Haube einen Schritt der Ausbildung einer Durchführung (30) in der Kappe (22) zum elektrischen Anschluss der mindestens einen Gegenelektrode (32) umfasst.

3. Verfahren nach Anspruch 1 oder 2, **dadurch gekennzeichnet, dass** der Schritt der Ausbildung der Haube einen Schritt der Ausbildung eines elektrischen Anschlusselements (36) unter der Haube zum elektrischen Anschluss der Pendelelektrode (20) und einen Schritt der Ausbildung einer Durchführung (28) in der Haube (22) zum elektrischen Anschluss des Elements (36) umfasst.

4. Verfahren nach einem der vorhergehenden Ansprüche, **dadurch gekennzeichnet, dass** das eutektische Material eine Legierung aus Gold und Silicium, eine Legierung aus Gold und Indium oder eine Legierung aus Gold und Zinn ist.

5. Verfahren nach einem der vorhergehenden Ansprüche, **dadurch gekennzeichnet, dass** es darüber hinaus das Integrieren eines Getters (50) zwischen der Haube (22) und dem Substrat (12) umfasst.

6. Verfahren nach einem der vorhergehenden Ansprüche, **dadurch gekennzeichnet, dass** der Sensor ein Beschleunigungsmesser ist, der in der Lage ist, eine lineare Beschleunigung zu messen.

7. Verfahren nach einem der Ansprüche 1 bis 5, **dadurch gekennzeichnet, dass** der Sensor ein Gyrometer ist, das in der Lage ist, eine Winkelbeschleunigung zu messen.

## Claims

1. A method of manufacturing a pendulous acceleration sensor (10) comprising the formation of a pendulous electrode (20) in the thickness of a substrate (12), comprising the steps of:
■ forming an encapsulation cover (22) provided with at least one counter electrode (32) thereunder;
■ forming spacers (52) of preset length under the cover (22) and/or on the substrate (12); and **characterized in that** it comprises the steps of :
· plating a eutectic coating (76) under the cover (22) and/or on the substrate (12), the thickness of the material being greater than the length of the spacers;
· positioning the cover (22) on the substrate (12); and
· fusing the eutectic material (76).

2. The method as claimed in claim 1, **characterized in that** the step of forming the cover comprises a step of forming a duct (30) in the cover (22) for the electrical connection of the at least one counter electrode (32).

3. The method as claimed in claim 1 or 2, **characterized in that** the step of forming the cover comprises a step of forming an electrical connection element (36) under the cover for the electrical connection of the pendulous electrode (20), and a step of forming a duct (28) in the cover (22) for the electrical connection of said element (36).

4. The method as claimed in any one of the previous claims, **characterized in that** the eutectic material is an alloy of gold and silicon, an alloy of gold and indium, or an alloy of gold and tin.

5. The method as claimed in any one of the previous claims, **characterized in that** it further comprises the integration of a getter (50) between the cover (22) and the substrate (12).

6. The method according to any of the preceding claims **characterized in that** said sensor is an accelerometer able to measure linear acceleration.

7. The method according to any of claims 1 to 5 **characterized in that** said sensor is a gyrometer able to measure angular acceleration.
